# EUROPEAN PATENT SPECIFICATION

(11) **EP 0 347 759 B1**
(45) Date of publication and mention of the grant of the patent: **10.08.1994**
(21) Application number: 89110915.9
(22) Date of filing: 16.06.1989
(51) Int. Cl.: H03K 19/017

(54) **Speed enhancement technique for CMOS circuits**
Verfahren zum Erhöhen der Geschwindigkeit für CMOS-Schaltungen
Méthode d'accroissement de la rapidité pour circuits CMOS

(30) Priority: 24.06.1988 US 210969
(43) Date of publication of application: 27.12.1989
(60) Divisional application: 94100767.6
(73) Proprietor: NATIONAL SEMICONDUCTOR CORPORATION, Santa Clara California 95051-8090 (US)
(72) Inventor: Proebsting, Robert J., Los Altos, CA. 94022 (US)
(74) Representative: Sparing - Röhl - Henseler Patentanwälte

(56) References cited:
- EP-A- 0 176 226
- US-A- 3 378 783
- IBM Technical Disclosure Bulletin, vol. 31 no. 5, October 1988; p. 258-260; "Proposed receiver circuits"
- PATENT ABSTRACTS OF JAPAN, vol. 10 no. 306 [E-446][2362] October 17, 1986 & JP-A-61 118 023 [TOSHIBA CORP]
- I.E.E.E. Journal of Solid-State Circuits, vol. 23, no. 5; October 1988; D. DESCHACHT et al.: "Explicit formulation of delays in CMOS data paths"; p. 1257-1264
- U Tietze, Ch.Schenk, "Halbleiter-Schaltungstechnik" 5th edition, Springer Verlag Berlin/Heidelberg/New York, pages 135 and 136, chapter 8.3 "Monostabile Kippschaltung"
- J.Markus "Modern Electronic Circuits Reference Manual", McGraw-Hill Book Company, 1980, page 605, circuit "Chained Astables"

## Description

This invention relates to circuits employing field effect transistors, and in particular to a technique for substantially increasing the speed of operation of circuits employing complementary field effect transistors.

In MOS circuits the speed of operation is limited by resistance and capacitance, the resistance of an MOS transistor driving the capacitance of the next MOS transistor. Because the output current of an MOS transistor is proportional to its channel width, if a narrow transistor is employed to drive a high capacitance load, a series of cascaded inverters are frequently used. In such circuits the time delay for each stage is proportional to the fan-out (load capacitance) of that stage, which is the ratio of the size (channel width) of the driven device or devices to that of the driving device or devices. Thus, the choice of relative sizes of the driving and driven devices affects the speed of the circuit.

Because the speed of any given inverter stage is a constant times the fan-out of that stage, if a specified fan-out is to be driven using a series of inverters, there are many possible choices. For example, consider a load of 100. If a single inverter with a fan-out of 100 is employed (a 4-micron width stage driving a 400-micron width stage), then the circuit will have a delay of 100 units of time because the delay is a constant times the fan-out. Alternatively, two serial inverter stages could be employed, each with a fan-out of 10, to provide a total fan-out for the circuit of 10 times 10 or 100, yet this driving arrangement has a delay of only 20 units of time (two delays, each of ten units of time). If four inverters are employed, each will have a fan-out of the square root of 10 and the total circuit delay will be four times the square root of 10, or about 12.65 units of time.

Thus, a circuit designer is presented with a range of choices for the number of stages to drive a given size load. There is an optimum number of stages; however, at which the total delay for the circuit is minimized, and that total delay may not be further reduced using conventional techniques. This minimum delay is reached when the size of each stage is the natural logarithm e (approximately 2.7) times the size of the previous stage. In other words, the total channel width of the devices in each subsequent stage is approximately 2.7 times the total channel width of the devices in the preceding stage.

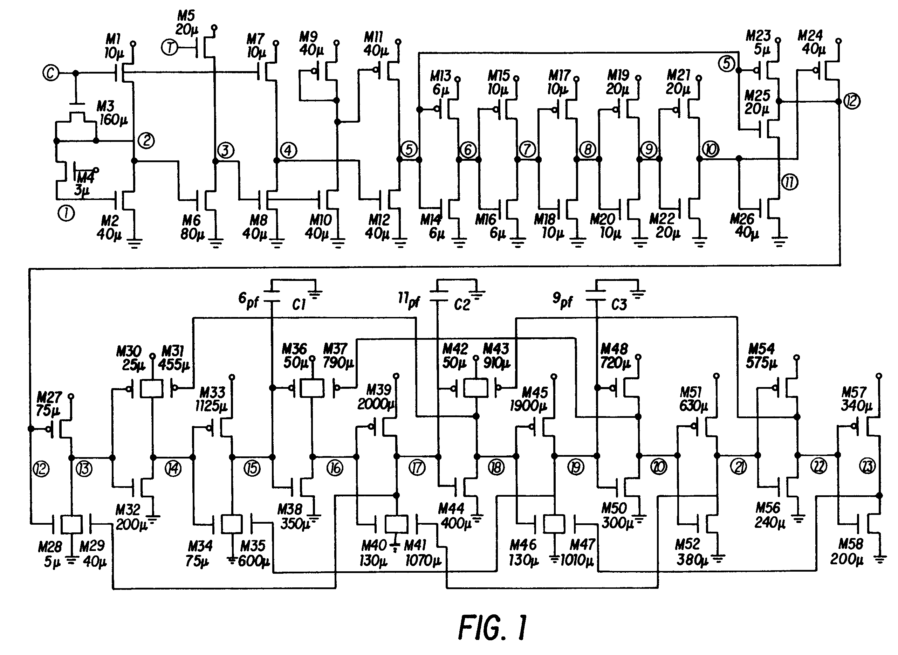

A basic complementary field effect transistor inverter includes a PMOS device connected between a positive supply and an output node and an NMOS device connected between the output node and a negative supply with the gates connected in parallel and to the input. For example, see the inverter between nodes 7 and 8 in Figure 1. In such an inverter the input signal going high (to the positive supply voltage) turns off the PMOS device to disconnect the common output node from the high potential, and turns on the NMOS device to pull the output node low by connecting it to the negative supply potential. Because an NMOS device is approximately twice as conductive as a PMOS device for a given gate width and turn-on voltage, by making the NMOS device approximately half the width of the PMOS device, the inverter will have a constant delay for both high-to-low or low-to-high logic transitions.

In all transistors, the channel length usually will be the minimum allowed by the manufacturing technology employed because short channel devices have both low on resistance and low capacitance to minimize switching time. Thus, in a typical inverter chain, a first inverter might include a 10-micron PMOS device and a 5-micron NMOS device. The following inverter (with near optimum fan-out of approximately three) therefore would include a 30-micron PMOS device and 15-micron NMOS device. The third inverter would have a 90-micron PMOS device and a 45-micron NMOS device, etc. In the first inverter the 5-micron NMOS device is driving both a 30-micron PMOS device and 15-micron NMOS device in the second inverter for total of 45 microns, or an NMOS fan-out of 9. Similarly, the 10-micron PMOS device in the first inverter is driving a 30-micron PMOS device and a 15-micron NMOS device in the second inverter for a PMOS fan-out of 4.5. Because the PMOS device is half as conductive as an NMOS device of the same size, the 10-micron PMOS will have a delay equivalent to that of the 5-micron NMOS driving the same load.

In each stage both the NMOS device and the PMOS device are turning on the PMOS device and turning off the NMOS device in the following inverter. Because in each inverter the PMOS device is twice the size of the NMOS device, two-thirds of the charge from the previous NMOS device will go to the PMOS device and one-third to the NMOS device. Similarly, the PMOS device in each inverter will send one-third of its charge to the NMOS device in the following inverter and two-thirds to the PMOS device in the following inverter. Thus, charge from each device in a preceding stage is supplied to each device in a following stage.

EP-A-176 226 discloses a circuit including a field effect transistor inverter chain and a latch for producing pulses of constant width regardless of the width of an input pulse. The latch forms simultaneously a reset circuit in that its output is connected to the reset transistor of the first inverter chain stage.

IBM Technical Disclosure Bulletin Vol. 31 No. 5 Oct. 1988 discloses a field effect transistor inverter chain wherein nodes of subsequent stages are coupled back to gates of transistors in previous stages in order to enhance the pullup action of said previous stage.

One form of CMOS logic in which speed is somewhat enhanced with respect to the inverter chain technique described above is domino logic. See, R. H. Krambeck, et al., "High-Speed Compact Circuits with CMOS," IEEE Journal of Solid-State Circuits (June, 1982) SC-17(3):614-619.

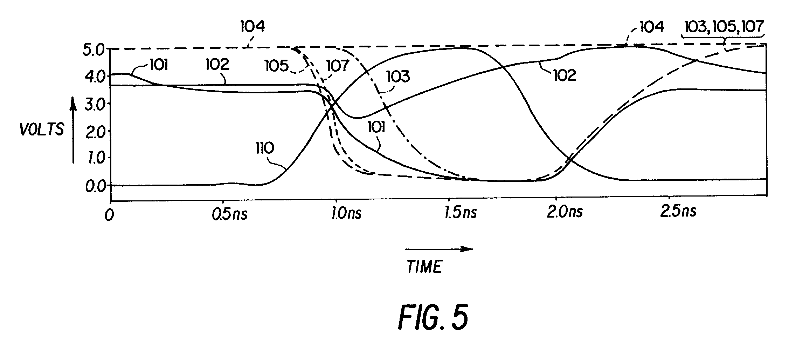

In domino logic circuits, an array of transistors is configured to perform a specified logic function. The output node is precharged to a particular voltage level (typically high for NMOS) while all current paths to the other voltage level (ground for NMOS) are turned off. During this phase the input to each of the gates of all transistors in the circuit are set to the desired level. Next, the current path to the high level is turned off by a clock signal, and the path to ground is turned on. Depending on the states of the input signals, the output node will either float at the high level or be pulled down, thereby evaluating the logic function implemented by the transistor array. The transition from precharge to evaluation is accomplished by a single clock edge applied simultaneously to all gate electrodes in the circuit. Figure 5 of the above paper shows a typical domino logic circuit.

Domino logic, however, suffers from several disadvantages. It operates at undesirably low speed because each logic gate drives an inverter consisting of both a PMOS and an NMOS transistor. It has low throughput because the multiple sequential stages receive a common precharge clock signal, and thus one complete clock cycle is required for each logic operation. Additionally, domino logic cannot provide logic functions in both NMOS and PMOS. Furthermore, in both the inverter chains and domino logic prior art, the logic functions are performed by changes in voltage levels. Because changes in the levels of output nodes are sensed after the circuit reaches a steady state condition, new input information cannot be applied until the circuit is stable. This results in delays until the entire circuit stabilizes, even though only a small portion may be changing.

### SUMMARY OF THE INVENTION

An object of the present invention is a circuit technique which allows circuits employing active components to operate substantially more rapidly than the speed achieved by prior art circuits. The invention is defined in broadest terms by patent claims 1 and 7. Preferably the invention is to employ pulses in CMOS circuits to perform only one of the two tasks performed by the voltage levels in prior art circuits. In circuits employing the invention, pulses are used to set a logic node to an active state, then some other pulse generated elsewhere (usually downstream) in the circuit is used to reset the node in preparation for the next active pulse. This technique allows virtually all of the charge from any given stage in a circuit (whether PMOS or NMOS) to be employed in setting a following stage to the active state, with virtually none wasted in resetting. This approach minimizes the time delay inherent in operation of the circuit. Additionally, the use of pulses, rather than levels, allows pipelining of circuit operation. Thus, while one part of the circuit is active, a preceding portion may be reset in anticipation of the next pulse.

In a preferred embodiment, a circuit fabricated according to the invention includes a plurality of cascaded stages, each stage capable of being placed in one of a first logic state or a second logic state. The active logic state of a selected stage is controlled by one or more stages immediately preceding the selected stage, while the inactive logic state is controlled by a stage following the selected stage. In alternate stages of logic, the active state will alternate between the high logic level and the low logic level.

In another embodiment a circuit fabricated according tothe invention includes a node, a logic circuit coupled to the node for placing the node in an active logic state at a first time, and a resetting circuit coupled to the node and responsive to the logic states of that node for resetting the node to the inactive state at a second time after the first time in response to the active logic state of the node at the first time.

In still a further embodiment of the invention, the circuit includes a high reference potential, a low reference potential, and a plurality of cascaded stages. Each stage comprises one or more PMOS field effect transistors connected between the positive supply node and an output node and one or more NMOS transistors connected between the output node and the negative supply to form a logic stage. The active logic state of a stage is controlled by the input nodes of that stage, (the output nodes of the immediately preceding stage) while the inactive logic state is controlled by the output node of a later stage.
Figure 1 is a schematic of a clock pulse generator circuit;
Figure 2 is a timing diagram for the upper portion of the circuit of Figure 1;
Figure 3 is a timing diagram for the lower portion of the circuit of Figure 1;
Figure 4 is a schematic of an input buffer which may be connected to the generator circuit of Fig. 1 but does not fall under the patent claims;
Figure 5 is a timing diagram for the input buffer circuit.

Figure 1 is a circuit schematic of a circuit fabricated according to the preferred technique of my invention. As will be discussed further below, the circuit technique of my invention has numerous applications to many different kinds of circuits. For illustration, the circuit shown in Figure 1 is a clock pulse generator circuit, which in response to an emitter-coupled logic (ECL) input signal, generates a clock pulse, amplifies that pulse, and then uses the amplified pulse to drive other circuits represented by capacitance loads C1, C2, and C3. The use of ECL is illustrative, and in practice any type of input signal can be used. The circuit shown includes three subcircuits, an emitter-coupled logic interface for amplifying the ECL logic input voltage levels to CMOS voltage levels (upper left portion of Figure 1), a pulse generator (upper right portion of Figure 1), and a fan-out circuit (lower portion of Figure 1) using the new techniques herein described for amplifying the drive capability of the pulses from the pulse generator.

The configuration and operation of the fan-out circuit will be described first, followed by a description of the other portions of the circuit which do not use the new techniques disclosed herein. The small circles on the gates of transistors denote PMOS transistors, while the other transistors are NMOS transistors. The circles shown on the sources or drains of the transistors of this and other figures represent connections to a positive reference potential V_{cc}, typically 5 volts.

Although the complementary MOS transistors, designated M27-M58 in the fan-out circuit, are configured into a series of logic stages, the operation of the circuit may be more readily understood by considering each transistor to have one of three different functions-primary signal path devices (set to active state), reset devices (set to inactive state), and power-up devices. The primary devices operate to fan-out pulses from the pulse generator, while the reset devices reset each node to a quiescent state in anticipation of the next pulse. The power-up devices function to place all nodes at the proper (inactive) levels when power is first applied to the circuit. In embodiments where each node can be assured to be at the proper level upon initial power-up, the power-up devices may be omitted.

Each of the CMOS logic stages between nodes 12 and 19 includes one device from each of the above categories. For example, transistors M30, M31, and M32 form a CMOS stage which, in response to an input signal on node 13, supplies a complementary signal on node 14. In this stage the primary signal path device is the large NMOS transistor M32 which has its gate connected to node 13, its drain connected to node 14, and its source connected to ground. The large reset PMOS transistor M31 has its source connected to the reference potential (V_{cc}), its drain connected to node 14, and its gate connected to an output node of a downstream stage, in this case the stage between nodes 17 and 18. Small PMOS transistor M30 functions as the power-up device, with source and drain connected in parallel to transistor M31 and with its gate connected to the input node 13. Every other stage in the fan-out circuit is similarly configured. For example, the inverter between nodes 17 and 18 has large NMOS transistor M44 as the set device, large PMOS transistor M43 as the reset device, and small PMOS transistor M42 as the power-up device. Because the chain stages must end somewhere, stages after the last load C3 (node 19) do not contain separate reset and power-up devices. (There is no later stage to do the reset.) For those stages only a single device is employed to perform both functions.

Alternating stages in the fan-out circuit employ complementary devices to those described above. For example, the stage between nodes 14 and 15 includes a large PMOS transistor M33 in the main signal path, and uses small NMOS transistors M34 and large NMOS transistor M35 to provide the power-up and reset functions, respectively. In this stage the PMOS device M33 has its gate connected to the input node, its source to the positive potential supply, and its drain to the output node, while the NMOS reset device M35 has its gate connected to a downstream stage, its source to ground, and its drain to the output node. The power-up device M34 has its source and drain connected in parallel to the reset device M35 and its gate to the input node.

A series of capacitors C1, C2 and C3 connected to the stages represent loads being driven by the circuit. In an actual application of the fan-out circuit shown in Figure 1, other circuitry would be connected in place of the capacitors to receive the clock pulse signals from the generator circuit. Each picofarad of capacitance load C1, C2 and C3 is equivalent to driving approximately a 500-micron wide MOS gate. Thus, the 11 picofarad load on node 17 is representative of having that node drive about 5500 microns of gate width in external circuitry, which circuitry is not shown in Figure 1. Although only three loads are shown, it should be apparent that by extending the fan-out circuit, as many loads may be driven by the circuit as desired. In some dynamic RAM circuits over 20 loads are driven by a single circuit. Also, because the loads shown happen to all be connected to odd numbered nodes, they all have a positive-going pulse. If a negative pulse were required, the external circuitry would simply connect to the appropriate even-numbered node.

For illustration, transistor sizes (channel widths) have been shown on Figure 1. The dimensions provided are hypothetical and are included only to illustrate the relative sizing of transistors throughout the fan-out circuit. The channel length of the devices typically will be the smallest dimension achievable with the particular process used to form the circuit. Each stage depicted has a fan-out greater than one as it is driving a larger total output capacitance than it has input capacitance. As mentioned above, because the PMOS devices are approximately half as conductive as the same width NMOS devices, they have twice the delay for a given fan-out. Thus, to provide a constant delay for each stage in the chain, PMOS devices in the main signal path have a fan-out half that (3) of the NMOS devices (6) in the main signal path. For example, 75-micron PMOS transistor M27 is driving a combination of 25-micron PMOS transistor M30 and 200-micron NMOS transistor M32 for a total fan-out of 3 (225 ÷ 75 = 3). 200-micron NMOS transistor M32 has a fan-out of 6 because it drives both 1125-micron PMOS transistor M33 and 75-micron NMOS transistor M34 ((1125 + 75)/200 = 6).

The operation of the circuit shown in the lower portion of Figure 1 is as follows. Assume that when the circuitry is first turned on, node 12 is held high. The high signal on node 12 will turn off PMOS transistor M27 to disconnect node 13 from the reference potential. Node 12 being high will also turn on NMOS transistor M28 to connect node 13 to ground and pull it low, regardless of whether transistor M29 is on or off. The low level signal thereby established on node 13 will turn off transistor M32 to disconnect node 14 from ground potential, and will turn on PMOS transistor M30 to pull node 14 high, regardless of the state of transistor M31. Eventually, the high signal on node 12 will result in all even-numbered nodes 12-22 being high and all odd-numbered nodes 13-23 being low.

Next, assume that a negative-going edge is generated by the pulse generator circuit shown in the top half of Figure 1 and that this pulse is supplied on node 12. Because of the respective sizes of transistors M27 and M28, almost all of the charge in the pulse is placed on the gate of M27 to turn it on quickly. As a result node 13 will be pulled high. Note that the gate of NMOS transistor M29, connected to odd-numbered node 17, will be low and transistor M29 will be off at this time. This rising edge on node 13 will turn on transistor M32 to pull node 14 to ground, since transistors M30 and M31 are off at this time. Node 14 going low will turn on transistor M33 to pull node 15 up toward the reference supply, which turns on transistor M38 pulling node 16 low, etc.

The time delay between any two nodes changing state is a function of the fan-out and the type of device driving the circuit. Assume that the delay of an NMOS transistor driving a gate its own size (fan-out = 1) is 1 unit of time. Because delay is proportional to fan-out, an NMOS transistor driving a transistor six times its own width (fan-out = 6) will have a delay of 6. A PMOS transistor, however, having only half the conductance for a given width, has twice the delay of an NMOS for the same fan-out. Thus, a PMOS transistor driving a copy of itself (fan-out = 1) will have a delay of 2 while a PMOS transistor driving a transistor three times its own width (fan-out = 3) will have a delay of 6. For example, because NMOS transistor M32 is 200 microns in width, and is driving 1200 microns of total transistor width, the fan-out and delay for transistor M32 will be 6. In stages in which the main signal path is a PMOS device, for example, between nodes 12 and 13, the fan-out (the sum of the widths of M30 and M32 (225 microns) divided by the width of M27 (75 microns)) will be 3 and the delay 6. Reference to Figure 1 shows that node 12 is driving a total of 80 microns of transistor width. Two stages of delay later, node 14 is driving a total of 1200 microns of transistor width. Thus, the total fan-out is 1200/80 or 15 for the pair of stages, while the total delay for the pair of stages is 6 + 6 = 12 units of time.

Contrast this with a prior art string of conventional CMOS inverters. If we keep the NMOS fan-out of 6 and the PMOS fan-out of 3, we will have each inverter stage twice the size of the driving stage. That is, if one stage has a 20-micron NMOS and a 40-micron PMOS, the preceding stage will have a 10-micron NMOS (fan-out = 6) and a 20-micron PMOS (fan-out of 3). This old art provides a fan-out of 2 per stage with a delay of 6 units of time per stage. To get a total fan-out of 16, 4 stages are required (2⁴ = 16) having a delay of 6 units of time per stage for a total delay of 24 units of time.

To reset each node at the appropriate level in anticipation of the next pulse, the reset transistors are driven by downstream inverters. For example, transistor M31 is driven by node 18, rather than node 13. This technique places the charge requirements for pulling node 14 high to reset it for the next pulse on a downstream inverter having substantially larger transistors, where relatively small transistor M31 adds little percentage increase in capacitance on node 18. If the gate of transistor M31 were connected to node 13 as in prior art; however, it would triple the capacitance on node 13 and triple the delay of node 13. Thus, any selected node is reset by a pulse which passed that selected node earlier, but only after that pulse reaches the much larger downstream inverter which drives the reset transistor coupled back to the selected node. Because the input pulse to a node essentially needs to drive only a single (set) device rather than to also turn off a reset device, the switching speed is increased.

The signal at any node will be an active pulse terminating five inverter delays later. The circuitry in the top right portion of Figure 1 provides a negative pulse on node 12 as will be explained later. The negative edge on node 12 causes a positive edge on node 13 causing a negative edge on node 14, causing a positive edge on node 15, . . . and causing a negative edge on node 13 through NMOS transistor M29. The positive edge on node 17 approximately coincides with the termination (positive edge) of the input pulse on node 12 so that PMOS transistor M27 does not interfere with resetting node 13 to its low inactive state.

Thus, the circuit of the invention provides about the same fan-out (15 vs. 16) in half the delay of prior art circuits. This is achieved because in the main signal path each switching device is driving essentially only one device in the following stage. The word "essentially" is used because if power-up devices are employed, a small percentage of the charge will flow to that device, even though almost all of the charge flows to the set device. That is, M32 drives M33 which drives M38 which drives M39 which drives M44, etc. Thus, essentially all of the charge from each transistor in the set path is used to switch the next transistor in the set path, while very little of the charge is used to turn off the reset path. The inverters between nodes 19 and 20, nodes 20 and 21, nodes 21 and 22, and nodes 22 and 23 only provide drive current to reset nodes in the upstream inverters to which they are connected. Because the string of stages has to end somewhere, the stages at the end of the string are not reset by later inverters.

The circuit technique described has the advantage of eliminating the burden of resetting any given node from the input signal and placing that burden on a downstream stage in which the transistors are sufficiently large so that they may readily drive the much smaller upstream device with little speed penalty. Because pulses are employed of appropriate width, generated in a manner discussed below, the reset pulse originating from a downstream stage is received by the upstream stage at an appropriate instant to reset the upstream stage, and not at an instant when the upstream stage is being pulled in the opposite direction by its input node.

It should be evident that the choice of how far "downstream" to select for the origin of the feedback signal is somewhat arbitrary. For Figure 1 a four-inverter delay is employed; however, any even number could be used. With a two-inverter delay a virtual triangular wave results, wasting much of the charge, while a six-inverter delay unnecessarily delays how soon a second set (active) pulse can follow a first set pulse.

Across the upper portion of Figure 1, a circuit is depicted which is used to generate negative pulses at node 12 from positive transitions on node 5. In the upper right-hand corner of the figure, transistors M23, M24, M25 and M26 form a two-input NAND gate. Nodes 5 and 10 must each be high to turn on NMOS transistors M25 and M26, and turn off transistors M23 and M24. This pulls the output node 12 to ground. If either of nodes 5 or 10 is low, then one of PMOS transistors M23 or M24 will be on and one of the NMOS transistors M25 or M26 will be off and node 12 will be high.

Connected between nodes 5 and 10 are a series of five CMOS inverters each comprising one PMOS and one NMOS transistor. For example, the inverter between nodes 6 and 7 includes a PMOS transistor M15 and an NMOS transistor M16. With an odd number of inverters between nodes 5 and 10, on a DC basis, nodes 5 and 10 will be out of phase with each other. If node 5 is low, node 6 is high, node 7 low, node 8 high, node 9 low, and thus node 10 is high. Since node 5 is low, node 12 is high. When node 5 next transitions to a high level, for a short time both nodes 5 and 10 will be high, thereby pulling node 12 low. Node 12 will remain low until the high level on node 5 propagates through the chain of inverters, making node 6 low, node 7 high, node 8 low, node 9 high, and node 10 low, thereby pulling node 12 high again. Thus, the positive transition on node 5 causes a negative pulse on node 12. Node 12 will remain high until the next positive transition on node 5. For any steady state, high or low, on node 5, the steady state of node 12 is high. Only when node 5 transitions high is a negative pulse supplied from node 12. The number of inverters between nodes 5 and 10 and the fan-out of each inverter is chosen such that the pulse width on node 12 is approximately equal (or a little shorter) than the feedback pulse timing. That is, when node 5 goes high, the following two sequences of events occur: (1) node 6 goes low, node 7 high, node 8 low, node 9 high, node 10 low, node 12 high; (2) node 12 low, node 13 high, node 14 low, node 15 high, node 16 low, node 17 high. The timing is adjusted such that node 12 goes high about the same time or slightly earlier than node 17 goes high, terminating the positive (active) pulse on node 13.

The circuit shown to the left of node 5 is an ECL interface circuit. Whenever the true T and complementary C input ECL level signals change phase, node 5 will change state (CMOS voltage levels). For example, if node C goes low and node T goes high, node 5 will be pulled high. Node 5 will be pulled low when nodes T and C next change back.

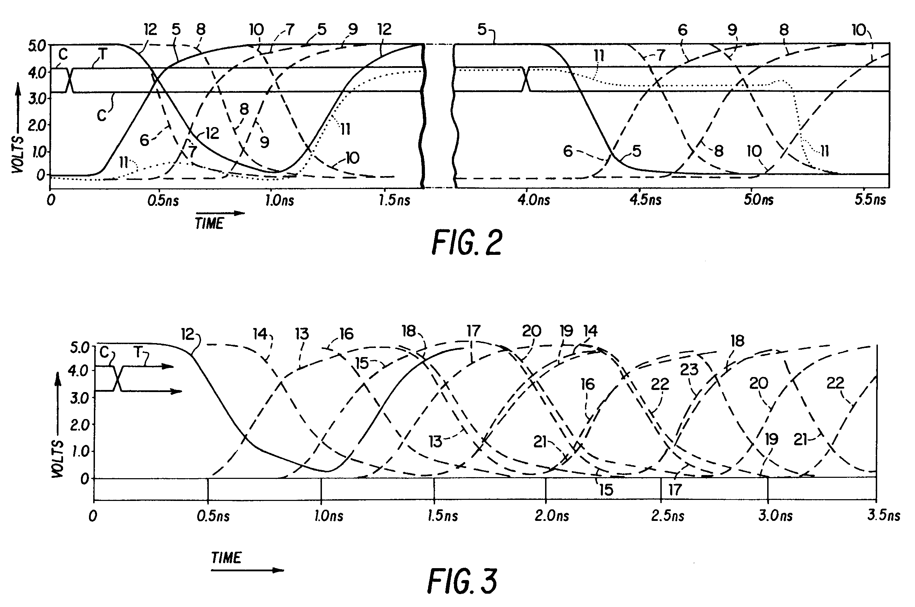

Figure 2 is a timing diagram which illustrates the operation of the circuit in the upper portion of Figure 1. The vertical axis of Figure 2 represents voltage in increments of 1 volt, while the horizontal axis represents time, with intervals of 0.5 nanoseconds marked on the figure. At time 0 node C is at 4.125 volts and node T at 3.250 volts. At 90 picoseconds, nodes C and T are switched by well known external ECL circuitry not shown) whose positive supply is connected to 5 volts and whose negative supply is connected to 0 volts so that node T goes high and node C goes low. This switching is assumed to be extremely fast, with only about 20 picoseconds required to change the state of the two nodes. The nodes will need to remain in this new condition, with node T high and node C low for about 1 nanosecond to obtain the correct negative pulse width from node 12. Arbitrarily, at 4 nanoseconds they are switched back to their original level. Thus, in Figure 2 node C is shown initially as high and switching to low at 100 picoseconds, then remaining low until 4 nanoseconds at which time it is switched back to high. Node T is switched opposite node C. The switching of the true T and complement C input signals at 100 picoseconds propagates through nodes 2, 3 and 4 to cause node 5 to go high at about 900 picoseconds. Node 5 rising causes node 12 to go low, starting a negative pulse. Node 5 rising also causes node 6 to fall, causing node 7 to rise, node 8 to fall, node 9 to rise, and node 10 to fall as shown in the first half of Figure 2. Node 10 falling causes node 12 to go high, terminating the negative pulse on node 12. After approximately 4 nanoseconds, the true and complement signals change state, causing node 5 to fall as shown in the second portion of Figure 2, but having no effect on node 12, since a low voltage on node 5 maintains a high output on node 12. Node 5 falling causes node 6 to rise, node 7 to fall, node 8 to rise, node 9 to fall, and node 10 to rise. Thus, by the end of the time period shown in Figure 2, node 12 is high and node 5 is low. Only when node 5 transitions high is a negative pulse at node 12 generated. When 5 returns to low, nothing happens at node 12.

Figure 3 illustrates the effect of the negative pulse at node 12 on the circuitry shown in the lower portion of Figure 1. As node 12 goes low, it drives PMOS transistor M27 to pull node 13 high. The low pulse on line 12 also turns off a very small NMOS transistor M28. Because of the respective sizes of the transistors, nearly all of the charge from node 12 flows into the gate of M27 to pull node 13 high. As node 13 goes high in the period between 0.5 and 1 nanosecond, most of the charge flows into NMOS transistor M32 to pull node 14 low about 0.2 nanoseconds later. As shown by Figure 3, node 14 going low pulls node 15 high quickly, which in turn pulls node 16 low quickly, and node 17 high in the same manner. The low impedance signal at node 17 has minimal difficulty, compared to the high impedance signal at node 12, driving the relatively small NMOS transistor M29 to then reset node 13. Tiny transistor M28 slightly helps reset node 13, since node 12 goes high about the same time node 17 goes high. As shown by Figure 3, node 13 which started high at 0.5 nanoseconds is almost back to 0 volts at 1.8 nanoseconds. Thus, the negative pulse on even-numbered node 12 causes a positive pulse on odd-numbered node 13. The negative pulse on any even-numbered node from 12 to 22 causes a positive pulse on the following odd-numbered node which in turn causes a negative pulse in the next even-numbered node. Thus, a pulse propagates, first negative on one node, then positive on the next node, then negative on the following node, etc. After an active pulse occurs, it is terminated by a reset pulse which is actually the active pulse of a downstream inverter. After the reset pulse terminates, the node is ready to accept a new active pulse.

In the course of switching a CMOS inverter from one state to the other state, when the input is halfway between the two supplies, both transistors are momentarily on resulting in DC power consumption across that inverter. Thus, it is desirable to have the top transistor turn off slightly before the bottom transistor turns on, if the output node is being pulled down, or to have the top transistor turn on later than the bottom transistor turns off, when the output node is being pulled high. This effect can be partially achieved by adjusting the signal timing. One example of this is shown in Figure 3 in the time period between 1.5 nanoseconds and 2 nanoseconds, where node 13 goes low (turning off NMOS M32) slightly ahead of node 18, which is turning on transistor PMOS M31 to pull node 14 high. Similarly, node 15 goes low to turn off transistor NMOS M38 slightly before node 20 goes low, turning on PMOS transistor M37. As another example, in the time period between 2.0 and 2.5 nanoseconds, node 16 goes high slightly before node 21, turning off PMOS transistor M39 slightly before NMOS transistor M41 is turned on. Although both are still momentarily on at the same time, the amount of overlap is reduced.

This adjustment in signal timing is achieved by appropriate sizing of the transistors. While above it was described that in the forward direction the NMOS device drives a fan-out of 6 and the PMOS drives a fan-out of 3, in the feedback direction slightly different loads are employed. For example, node 16 is pulled low by a 350 micron NMOS device, but instead of having a PMOS device twice that size, a slightly larger PMOS device is employed, specifically transistor M37 with 790 microns width, representing a 20% increase in size over the 2:1 rule for the forward direction. This transistor sizing makes node 16 go high slightly more rapidly than it goes low. Thus, node 16 turns transistor M39 off relatively faster than transistor M41 is turned on, avoiding undesirable power consumption.

The circuitry described thus far involves decreasing the delay through a string of inverters rather than through a string of more complex logic gates. But the inventive concept of propagating a pulse rather than a logic level, and of terminating the pulse by a pulse generated downstream, applies equally well to a string of logic gates as to simple inverters.

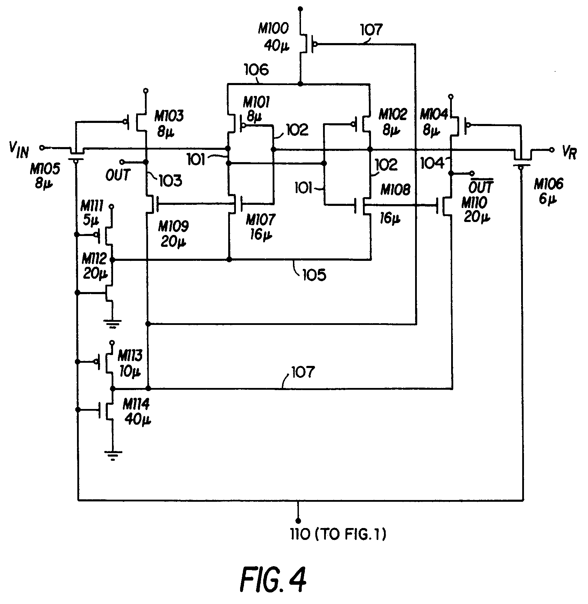

Figure 4 is a circuit schematic of an input buffer employing the speed enhancement technique for CMOS circuits. The input buffer, typically employed in a random access memory, compares an ECL level input voltage at node VIN with a reference voltage level, representing the middle of the ECL range, applied to node VR. In response to these signals, the circuit, as rapidly as possible, generates a negative-going pulse on one of two output nodes dependent upon the relative voltages of the signals VIN and VR. The circuit supplies the pulse or no pulse as a true output, and no pulse or a pulse as a complementary output. This circuit resets nodes from the active state back to the inactive state at the termination of the input pulse on node 110.

Node 110, in the lower portion of the figure, is connected to receive positive pulses from another circuit, such as the clock pulse generator shown in Figure 1. For example, node 110 could be connected directly to node 15 in Figure 1, and in fact a number of input buffers together represent the 6 picofarad load C1. While node 110 is low (inactive), PMOS devices M105 and M106 are conductive, thereby connecting VIN to node 101 and VR to node 102. Transistor M111 is conductive and transistor M112 nonconductive so that node 105 is high. Transistor M113 is conductive and transistor 114 nonconductive thereby also holding node 107 high.

At the time node 110 goes high, in response to the rising edge of a pulse propagating through the circuitry of Figure 1, transistors M105 and M106 are turned off. Additionally, transistor M111 is turned off, and transistor M112 turned on to pull node 105 to ground. Similarly, transistor M113 is turned off, and transistor M114 turned on to pull node 107 to ground. Because node 107 is driving a considerably larger load in PMOS transistor M100 than is node 105, node 107 will come to ground slightly slower than node 105.

Transistors M107 and M108 are cross-coupled, with the drain of M108, node 102, coupled to the gate of M107, and the drain of M107, node 101, coupled to the gate of M108. Assume that node VIN is low compared to the reference voltage VR. Therefore, node 101 will be lower than node 102 and the capacitance on nodes 101 and 102 will temporarily maintain these relative voltages even after transistors M105 and M106 turn off. Because node 101 is lower than node 102, as node 105 is pulled to ground, transistor M107 will begin conducting earlier than transistor M108 (the gate of transistor M107 is coupled to the higher potential of node 102 compared to the gate of transistor M108 which is connected to the lower potential of node 101). It is assumed that the threshold voltages of transistors M107 and M108 are well matched. Thus, transistor M107 will pull node M101 down faster than equal-sized transistor M108 will pull node M102 down. As node M101 is pulled down, it will turn on PMOS transistor M102, since node 106 is pulled up by PMOS transistor M100 at this time. So as node 105 goes low, transistor 107 pulls node 101 low, and as node 101 goes low (with node 106 going high), transistor M102 pulls node 102 high. Therefore, there is the same regenerative cross-coupling in transistors M101 and M102 as in transistors M107 and M108. Thus, once node 105 is at ground and node 106 is at the positive supply reference potential, the circuit is configured as two inverters, one inverter comprising transistors M101 and M107, and the other inverter comprising transistors M102 and M108. Given an impetus by the potential applied to the node VIN being higher or lower than VR, the inverters will switch one way or the other.

Figure 5 is a timing diagram illustrating the switching action just described. As node 105 falls (ahead of node 107), both nodes 101 and 102 (VIN and VR) begin falling, but their voltage levels separate due to the greater current through transistor M107 than that through transistor M108. This occurs for the period between 0.9 and 1.1 nanoseconds. Beginning at about 1.1 nanoseconds, however, node 102 begins rising due to the current through transistor M108 until by 2 nanoseconds the nodes are nearly 5 volts apart. This has occurred in response to node 110 going high, beginning at approximately 0.7 nanoseconds.

The primary delay between nodes 105 and 107 is the extra capacitance on node 107 caused by transistor M100. Node 102 is pulled low for a short period when node 105 falls more than one threshold voltage below node 101, thereby causing some conduction through transistor M108. Node 107, however, being slightly delayed with respect to node 105, never gets appreciably more than one threshold voltage below node 101. Therefore, there is very little, if any, conduction through transistor M110, and output node 104 is not appreciably discharged. Node 102, on the other hand, goes up to the positive supply while node 107 goes low, turning on transistor M109 discharging output node 103. Thus, there is a negative output (pulse) on node 103 while the complementary output node 104 remains at the positive supply reference voltage. With a high input voltage on VIN, the negative pulse will occur instead at node 104.

Node 110 is supplied with a positive pulse. Once the pulse passes and node 110 returns negative, the transistor M103 will be turned on, pulling node 103 back to its inactive reference potential, as shown at the ultimate right-hand side of Figure 5. All other nodes are also reset to their inactive state, since nodes 105 and 107 go positive while nodes 100 and 102 reset to V_{IN} and V_{R}, respectively. Thus, a pulse has been created on node 103 and no pulse created on node 104. This pulse will be later used in a decoder circuit.

## Claims

1. A field effect transistor circuit comprising a chain of k [k>1] inverter stages of a first type followed by m [m being an even number >0] stages of a second type, wherein each stage of said first type comprises a pair of transistors of opposite conductivity coupled to a common output (13) of the respective stage, the control electrode of one (M27) of said pair of transistors being coupled to an input (12) of the respective stage, and the control electrode of the other (M29) of said pair of transistors being coupled to the output node (17) of the m^{th} stage following the output of the respective stage.

2. The circuit of claim 1 wherein each inverter stage comprises a series connection of said one and said other transistor coupled with their drains to said common output and with their sources to a first and a second potential source, respectively.

3. The circuit of claim 2 wherein each inverter stage further comprises a third field effect transistor (M28) connected with its source-drain-path in parallel to the source-drain-path of said other transistor and with its gate connected to said input.

4. The circuit of claim 3 wherein said one and said third transistor are of complementary type.

5. The circuit of one of claims 1 to 4 wherein m is four.

6. The circuit of claim 2 wherein in odd-numbered stages said one transistor (M27, M33...) is connected to said first potential source and in even-numbered stages said one transistor (M32, M38...) is connected to said second potential source.

7. A method of operating the circuit as set forth in claim 1 wherein an input pulse is applied to said control electrode of said one transistor in a respective stage of said k [k>1] stages of first type to thereby cause said stage to change state and using said change of state to cause the m^{th} stage thereafter to generate a reset signal applied to the control electrode of said other transistor of the respective stage to cause a rechange of state prior to arrival of another input pulse.

## Patentansprüche

1. Eine Feldeffekt-Transistorschaltung mit einer Kette von k [k>1] Inverterstufen eines ersten Typs, gefolgt von m [m ganzzahlig >0] Stufen eines zweiten Typs, wobei jede Stufe des ersten Typs ein Paar von Transistoren entgegengesetzter Leitfähigkeit umfaßt, die an einem gemeinsamen Ausgang (13) der entsprechenden Stufe angekoppelt sind, wobei die Steuerelektrode eines (M27) aus dem Paar von Transistoren mit einem Eingang (12) der entsprechenden Stufe gekoppelt ist und die Steuerelektrode des anderen (M29) aus dem Paar von Transistoren mit dem Ausgangsknoten (17) der m^{ten} Stufe hinter dem Ausgang der entsprechenden Stufe gekoppelt ist.

2. Die Schaltung nach Anspruch 1, bei der jede Inverterstufe eine Serienschaltung des genannten einen und des genannten anderen Transistors umfaßt, die mit ihren Drains an den gemeinsamen Ausgang angeschlossen sind und mit ihren Sources an eine erste bzw. zweite Potentialquelle.

3. Die Schaltung nach Anspruch 2, bei der jede Inverterstufe ferner einen dritten Feldeffekt-Transistor (M28) umfaßt, der mit seinem Source-Drain-Pfad parallel zum Source-Drain-Pfad des genannten anderen Transistors gelegt ist und dessen Gate mit dem Eingang verbunden ist.

4. Die Schaltung nach Anspruch 3, bei der der genannte eine und der genannte dritte Transistor von komplementärem Typ sind.

5. Die Schaltung nach einem der Ansprüche 1 bis 4, bei der m gleich vier ist.

6. Die Schaltung nach Anspruch 2, bei der in ungeradzahligen Stufen der genannte eine Transistor (M27, M33...) mit der ersten Potentialquelle und in geradzahligen Stufen der eine Transistor (M32, M38...) mit der zweiten Potentialquelle verbunden sind.

7. Ein Verfahren zum Betrieb der Schaltung nach Anspruch 1, bei dem ein Eingangsimpuls an die Steuerelektrode des genannten einen Transistors in einer entsprechenden Stufe der genannten k [k>1] Stufen vom ersten Typ angelegt wird, um dadurch in dieser Stufe eine Zustandsänderung zu bewirken und diese Zustandsänderung verwandt wird, um die m^{te} Stufe dahinter zum Erzeugen eines Rücksetzsignals zu bringen, das an die Steuerelektrode des genannten anderen Transistors der entsprechenden Stufe angelegt wird zum Herbeiführen einer Rückänderung des Zustands vor dem Eintreffen eines anderen Eingangsimpulses.

## Revendications

1. Circuit à transistors à effet de champ comprenant une chaîne de k (k>1) étages inverseurs d'un premier type suivie de m (m étant un nombre pair >0) étages d'un second type, dans lequel chaque étage dudit premier type comprend une paire de transistors de conductivités opposées, couplés à une sortie commune (13) des étages respectifs, l'électrode de commande de l'un (M27) des transistors de ladite paire étant connectée à une entrée (12) de l'étage respectif, et l'électrode de commande de l'autre (M29) de ladite paire de transistors étant connectée à la jonction de sortie (17) du m^{ième} étage qui suit la sortie de l'étage respectif.

2. Le circuit de la revendication 1 dans lequel chaque étage inverseur comprend une connexion en série du premier et du second transistors connectés par leurs drains à ladite sortie commune, leur source étant respectivement connectée à des première et seconde sources de potentiel.

3. Le circuit suivant la revendication 2 dans lequel chaque étage inverseur comprend également un troisième transistor à effet de champ (M28) dont le trajet source - drain est connecté en parallèle au trajet source - drain du second transistor, sa grille étant connectée à ladite entrée.

4. Le circuit suivant la revendication 3 dans lequel ledit premier et ledit troisième transistors sont de types complémentaires.

5. Le circuit selon l'une quelconque des revendications 1 à 4 dans lequel m est égal à quatre.

6. Le circuit suivant la revendication 2 dans lequel dans les étages de numéros impairs, ledit premier transistor (M27, M33...) est connecté à ladite première source de potentiel et dans les étages de numéros pairs, ledit premier transistor (M32, M38...) est connecté à ladite seconde source de potentiel.

7. Un procédé de fonctionnement du circuit tel que défini dans la revendication 1 dans lequel une impulsion d'entrée est appliquée à ladite électrode de commande dudit premier transistor dans un étage respectif parmi lesdits k (k>1) étages du premier type pour que ledit étage change d'état, ledit changement d'état étant utilisé pour que le m^{ième} étage suivant engendre un signal de désactivation appliqué à l'électrode de commande dudit second transistor de l'étage respectif pour provoquer un nouveau changement d'état avant l'arrivée d'une autre impulsion d'entrée.
